# EUROPEAN PATENT APPLICATION

(11) **EP 4 530 646 A1**
(43) Date of publication of application: **02.04.2025**
(21) Application number: 23811497.9
(22) Date of filing: 12.04.2023
(51) Int. Cl.: G01R 31/12, G01R 31/00, G01R 31/52

(54) **ELECTRICAL DISCHARGE DETECTION SYSTEM**

(30) Priority: 23.05.2022 JP 2022083657; 17.01.2023 JP 2023005143
(71) Applicant: Nitto Kogyo Corporation, Nagakute-shi, Aichi 480-1189 (JP)
(72) Inventor: MIYAMOTO, Atsushi, Nagakute-shi, Aichi 480-1189 (JP); SAKAI, Tomoyasu, Nagakute-shi, Aichi 480-1189 (JP); UEKI, Hiyori, Nagakute-shi, Aichi 480-1189 (JP); ITO, Hiroyuki, Nagakute-shi, Aichi 480-1189 (JP); AITA, Yusuke, Nagakute-shi, Aichi 480-1189 (JP)
(74) Representative: Mewburn Ellis LLP
(86) International application number: PCT/JP2023/014867
(87) International publication number: WO 2023/228619

(57) **Abstract**

An electrical discharge detection system that detects an output of noise superimposed on a voltage or a current of an electric circuit to which a load is connected includes a filter unit capable of extracting an output waveform in a specific frequency band, a division unit capable of dividing a certain time into a plurality of domains, and a determination unit capable of confirming a degree of continuity of domains in which an output of noise has been confirmed or comparing outputs of noise of a domain group in which a plurality of domains is collected.

## Description

### TECHNICAL FIELD

The present invention relates to an electrical discharge detection system.

### BACKGROUND ART

As described in Patent Literatures 1 and 2, it is known to extract high-frequency electrical discharge noise superimposed on a commercial frequency using a current sensor or a voltage sensor. For example, in a method for detecting noise of a normal electrical discharge event, noise is superimposed on a peak value of a commercial frequency in a voltage waveform, and the superimposed noise is detected to determine that an electrical discharge event has occurred.

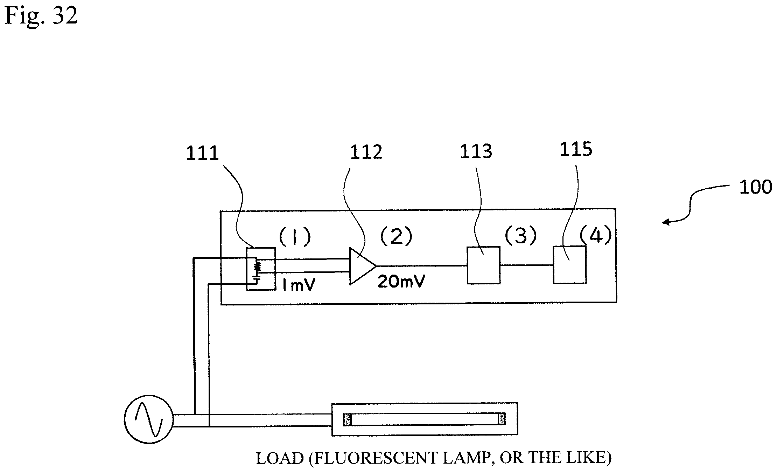

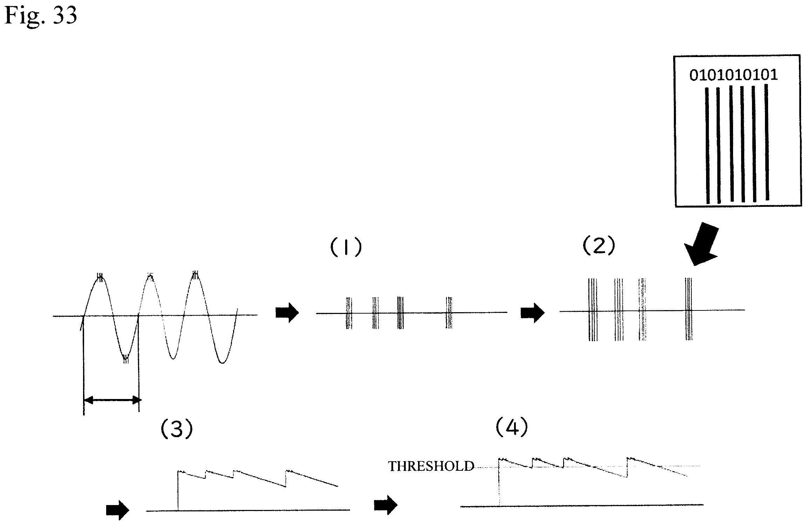

More specifically, using an electrical discharge detection unit 100 as illustrated in Fig. 32, a noise output in a high frequency band is extracted by a high-pass filter 111, and the noise output in the extracted high frequency band is amplified by an amplifier 112. Thereafter, a smoothing unit 113 performs processing so as to follow the flow of change in the amplified noise waveform. This processing is performed because the waveform amplified by the amplification unit 112 has a form in which 0 and 1 are repeated when seen in detail, and processing is performed to connect respective waveforms that cannot be accurately determined so that 1 continues (see Fig. 33). Data after this processing is performed is used for determination. Note that, for example, a microcomputer is used as a determination unit 115 that performs the determination. Normally, when the noise level exceeds the threshold for a certain period of time or more, the determination unit 115 determines that it is electrical discharge.

### CITATIONS LIST

### PATENT LITERATURE

Patent Literature 1: JP 2019-184480 A
Patent Literature 2: JP 2020-134231 A

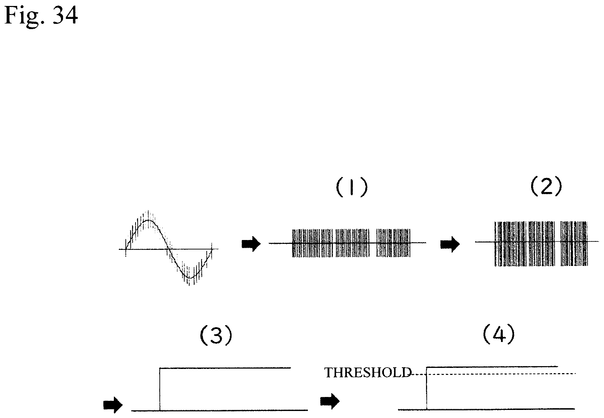

Incidentally, when a specific device such as an electric drill or a hand mixer including a specific motor is used, noise is always superimposed. In this case, even in a case where the processing in the filter, the amplification processing, and the smoothing processing are performed, the waveform to be determined becomes a waveform similar to that when the electrical discharge event occurs (see Fig. 34). Therefore, even though no electrical discharge event has occurred, it may be determined as an electrical discharge event.

### SUMMARY OF INVENTION

### TECHNICAL PROBLEMS

The inventors of the present application have intensively studied this point to attempt to solve the problem. The problem to be solved by the present invention is to improve accuracy of detection of an electrical discharge event.

### SOLUTIONS TO PROBLEMS

In order to solve the above problem, an electrical discharge detection system that detects an output of noise superimposed on a voltage or a current of an electric circuit to which a load is connected includes a filter unit capable of extracting an output waveform in a specific frequency band, a division unit capable of dividing a certain time into a plurality of domains, and a determination unit capable of confirming a degree of continuity of domains in which an output of noise has been confirmed or comparing outputs of noise of a domain group in which a plurality of domains is collected.

Furthermore, it is preferable to configure so that whether or not it is a state in which occurrence of an electrical discharge event to be handled is suspected is determined by confirming the degree of continuity of domains in which an output of noise has been confirmed or comparing outputs of noise of a domain group in which a plurality of domains is collected, and it is possible to determine that an electrical discharge event to be handled has occurred when the state in which occurrence of an electrical discharge event to be handled is suspected is treated to have been detected continuously for a predetermined time.

Furthermore, it is preferable to configure so that, even when it is determined not to be the state in which occurrence of an electrical discharge event to be handled is suspected at a stage of confirming continuity of the state in which occurrence of an electrical discharge event to be handled is suspected, when a state in which it is determined not to be the state in which occurrence of an electrical discharge event to be handled is suspected is within a predetermined time, control is performed so as to treat that the state in which occurrence of an electrical discharge event to be handled is suspected as continuing.

Furthermore, it is preferable to configure so that the determination unit is capable of determining a degree of progress of the electrical discharge event from a temporal change in data obtained in a domain determined by dividing a certain time into a plurality of times.

Furthermore, it is preferable to further include a plurality of filter units is provided so that at least one of the filter units is capable of extracting an output waveform in a frequency band different from a frequency band of another of the filter units, in which it is possible to perform control so as to determine continuity in a plurality of domains or compare noise outputs in each of the plurality of domains to determine suitability of each of the filter units.

Furthermore, it is preferable to configure so that control is performed so as to output a warning when it is determined that all the filter units capable of extracting output waveforms in mutually different frequency bands are not suitable.

Furthermore, it is preferable to configure so that it is possible to compare noise outputs by comparing domain groups having different numbers of domains.

Furthermore, it is preferable to further include a setting unit capable of setting so as to exclude an output in a domain of a specific time in any one of a peak time slot and a 0 value time slot from comparison targets.

Furthermore, it is preferable that domains settable to be excluded from the comparison targets include at least a start domain and an end domain in any one of the peak time slot and the 0 value time slot.

Furthermore, it is preferable to further include a setting unit capable of setting an output in a specific time domain in one of the peak time slot and the 0 value time slot as a comparison target in another of the time slots.

Furthermore, it is preferable that domains settable to be included in comparison targets include at least a start domain and an end domain in any one of the peak time slot and the 0 value time slot.

### ADVANTAGEOUS EFFECTS OF INVENTION

In the present invention, it is possible to improve accuracy of detection of an electrical discharge event.

### BRIEF DESCRIPTION OF DRAWINGS

Fig. 1 is a diagram illustrating an example of a relationship among a commercial power source, an electrical discharge detection unit, and a load according to an embodiment.
Fig. 2 is a diagram illustrating an example in which one cycle of a voltage waveform or a current waveform at a commercial frequency is divided into a plurality of domains. Note that (a) is an example in which one cycle is divided into 12 domains, and (b) is an example in which one cycle is divided into 24 domains.
Fig. 3 is a diagram illustrating an example in which noise is superimposed on a commercial current or the like when an electrical discharge event occurs. Note that, the main waveform represents a commercial current or the like, and represents a state in which noise is present at a part of the peak.
Fig. 4 is a diagram illustrating noise, a domain, and a determination example in a case where one cycle is divided into 12 domains. Here, (a) conceptually represents a position of each domain in a case where one cycle is divided into 12 domains, (b) represents a relationship between noise extracted by a filter unit and each domain, and (c) represents that whether or not a threshold is exceeded is determined for each domain. Note that "1" is written in a domain exceeding the threshold, and "0" is written in a domain not exceeding the threshold.
Fig. 5 is a diagram illustrating an example in which even when noise exceeding a first threshold is detected, it is not determined that there is a state in which occurrence of an electrical discharge event to be handled is suspected. Note that, (a) is an example in which the number of times noise exceeding the first threshold is continuously detected is insufficient, and (b) is an example in which the number of times noise exceeding the first threshold is continuously detected is too large.
Fig. 6 is a diagram illustrating that it is determined that an electrical discharge event to be handled has occurred when a state in which occurrence of an electrical discharge event to be handled is suspected continues for a third predetermined time. Note that, "1" is written in one cycle in which the occurrence of the electrical discharge event is suspected, and "0" is written in one cycle in which the occurrence of the electrical discharge event is not suspected.
Fig. 7 is a diagram illustrating that, when a state in which occurrence of an electrical discharge event to be handled is suspected continues for some time, even if it for an extremely short period occurs that the state in which occurrence of an electrical discharge event to be handled is suspected thereafter is not recognized, it is treated that the state in which occurrence of an electrical discharge event to be handled is suspected continues.

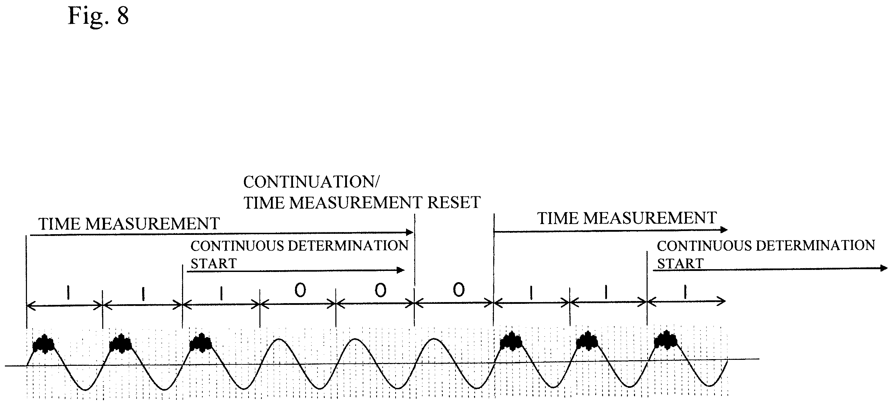

Fig. 8 is a diagram illustrating that, since it has continued for a while that a state in which occurrence of an electrical discharge event to be handled is suspected is not recognized after the state in which occurrence of an electrical discharge event to be handled is suspected is continued for some time, a time during which it is recognized that the state in which occurrence of an electrical discharge event to be handled is suspected continues is reset, but thereafter, a state in which occurrence of an electrical discharge event to be handled is suspected is generated, and measurement of a time during which it is recognized that the state in which occurrence of an electrical discharge event to be handled is suspected continues is started again.
Fig. 9 is a diagram illustrating that it is determined that there is a state in which occurrence of an electrical discharge event to be handled is suspected since domain groups which are clusters of three domains are compared and thereby it is confirmed that a difference thereof is equal to or more than a second threshold.
Fig. 10 is a diagram illustrating that noise is determined to be caused by a device since domain groups which are clusters of domains are compared and thereby it is confirmed that a difference thereof is less than the second threshold.
Fig. 11 is a diagram illustrating that it is determined that there is a state in which occurrence of an electrical discharge event to be handled is suspected since domain groups which are clusters of four domains are compared and thereby it is confirmed that a difference thereof is equal to or more than the second threshold.
Fig. 12 is a diagram illustrating that a domain group corresponding to a peak time domain of a voltage waveform or a current waveform at a commercial frequency and a domain group corresponding to a 0 value time domain are compared and thereby it is confirmed that a difference thereof is equal to or more than the second threshold, and thus it is determined that there is a state in which occurrence of an electrical discharge event to be handled is suspected.

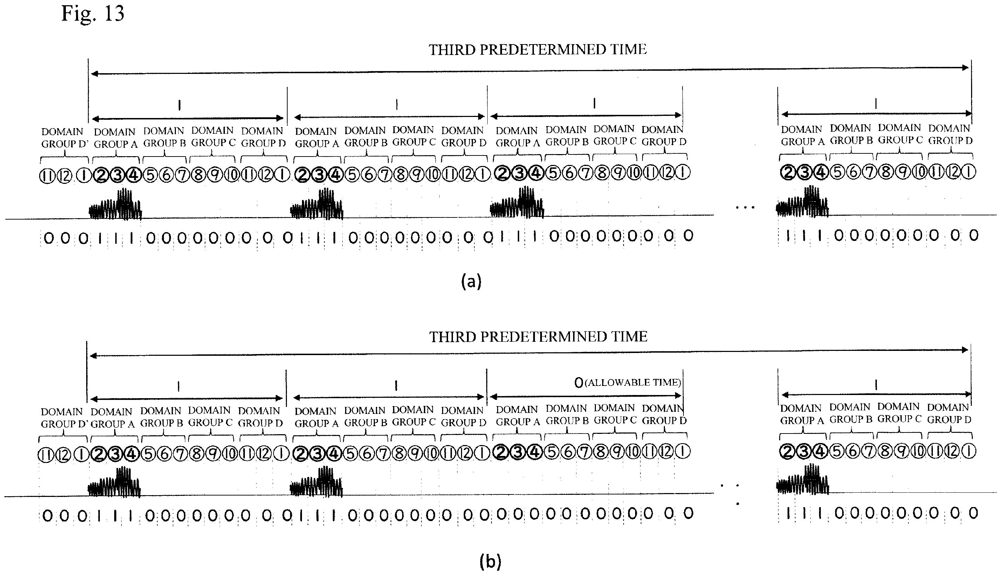

Fig. 13 is a diagram illustrating an example of determining continuity of a "state in which occurrence of an electrical discharge event to be handled is suspected" using a result of comparing domain groups. Note that, (a) is an example in which a state in which occurrence of an electrical discharge event to be handled is suspected has actually continued for the third predetermined time, and (b) is an example in which the state in which occurrence of an electrical discharge event to be handled is suspected is not recognized for an extremely short period in some cases, but it is treated as the state in which occurrence of an electrical discharge event to be handled is suspected during the time, and thus the state in which occurrence of an electrical discharge event to be handled is suspected is treated to having been continued for the third predetermined time. Note that, "1" is written in one cycle in which the occurrence of the electrical discharge event is suspected, and "0" is written in one cycle in which the occurrence of the electrical discharge event is not suspected.
Fig. 14 is a diagram illustrating that noise detected before a state in which occurrence of an electrical discharge event to be handled is suspected occurs grows with time.
Fig. 15 is a diagram in which a voltage waveform and a noise output in a case where a voltage is 100 V and a voltage waveform and a noise output in a case where the voltage is 200 V can be compared. Note that, (a) illustrates a voltage waveform and a noise output in a case where the voltage is 100 V, and (b) illustrates a voltage waveform and a noise output in a case where the voltage is 200 V.
Fig. 16 is a diagram illustrating an example in which a noise output caused by an electrical discharge event also appears in a 0 value time slot beyond a peak time slot. Note that, the voltage waveform is illustrated on the upper side, and the noise output at the corresponding timing is illustrated on the lower side.
Fig. 17 is a diagram illustrating an example of a relationship among a commercial power source, an electrical discharge detection unit, and a load when the electrical discharge detection unit illustrated in Fig. 1 further includes a comparison exclusion domain setting unit.
Fig. 18 is a diagram illustrating that domains at the start and end of a 0 value time slot are set to be excluded from comparison targets.
Fig. 19 is a diagram illustrating an example of a relationship among the commercial power source, the electrical discharge detection unit, and the load when the electrical discharge detection unit illustrated in Fig. 17 further includes an exclusion condition setting unit.
Fig. 20 is a diagram illustrating that domains at the start and end of a 0 value time slot are set to be excluded from comparison targets. Note that, the number of first exclusion domains is set larger than the number of final excluded domains.
Fig. 21 is a diagram illustrating that domains at the start and end of a peak time slot are set to be excluded from comparison targets.
Fig. 22 is a diagram illustrating that domains other than the start and end of the peak time slot are set to be excluded from comparison targets.
Fig. 23 is a diagram illustrating an example of a relationship among a commercial power source, an electrical discharge detection unit, and a load in a case where the electrical discharge detection unit illustrated in Fig. 19 further includes a learning unit.
Fig. 24 is a diagram illustrating that domains at the start and end of a 0 value time slot are set as comparison targets of the peak time slot.
Fig. 25 is a diagram illustrating that electrical discharge noise resulting from an electrical discharge event and device noise resulting from operation of a device may occur at the same time. Here, electrical discharge noise has a large value in a wide range of frequencies.
Fig. 26 is a diagram illustrating an example in which four filter units are switchably provided.
Fig. 27 is a diagram illustrating that four filter units detect different frequency bands.
Fig. 28 is a diagram illustrating an example in which it has been found that a first filter unit and a fourth filter unit are unsuitable for measurement of electrical discharge noise, but a second filter unit and a third filter unit can measure electrical discharge noise as a result of confirming suitability of the four filter units. Note that, by determining continuity in a plurality of domains, suitability is confirmed.
Fig. 29 is a diagram illustrating an example in which it has been found that the first filter unit and the fourth filter unit are unsuitable for measurement of electrical discharge noise, but the second filter unit and the third filter unit can measure electrical discharge noise as a result of confirming suitability of the four filter units. Note that, the suitability is confirmed by comparing noise outputs for each of the plurality of domains.
Fig. 30 is a conceptual diagram illustrating that after a predetermined time elapses from confirming of suitability of the four filter units, suitability is confirmed again.
Fig. 31 is a diagram illustrating an example in which the four filter units are always used for measurement.
Fig. 32 is a diagram illustrating an example in which a conventional electrical discharge detection unit is connected between a commercial power source and a load. Note that (1) to (4) represent portions where the processing of (1) to (4) in Figs. 33 and 34 is performed.
Fig. 33 is a diagram illustrating an example of a flow of processing from capturing a voltage waveform on which noise caused by occurrence of an electrical discharge event is superimposed to distinguishing an output for each domain using the conventional electrical discharge detection unit. Here, (1) represents a result of extracting the output waveform in a high frequency band, (2) represents a result of amplification, (3) represents a result of processing by a smoothing unit, and (4) represents that an output at the timing of the peak time domain and an output at the timing of the 0 value time domain are distinguished. Note that (2) is also a partially enlarged view.
Fig. 34 is a diagram illustrating an example of a flow of processing from capturing a voltage waveform on which noise due to use of a specific device is superimposed to distinguishing an output for each domain using the conventional electrical discharge detection unit. Here, (1) represents a result of extracting the output waveform in a high frequency band, (2) represents a result of amplification, (3) represents a result of processing by the smoothing unit, and (4) represents that an output at the timing of the peak time domain and an output at the timing of the 0 value time domain are distinguished.

### DESCRIPTION OF EMBODIMENTS

Hereinafter, modes for carrying out the invention will be described. The electrical discharge detection system of the present embodiment can detect an output of noise superimposed on a voltage or a current of an electric circuit to which a load 8 is connected. The electrical discharge detection system includes a filter unit 11 capable of extracting an output waveform in a specific frequency band, a division unit 13 capable of dividing a certain time into a plurality of domains, and a determination unit 16 capable of confirming a degree of continuity of domains in which an output of noise has been confirmed or comparing outputs of noise of a domain group in which a plurality of domains is collected. Thus, accuracy of detection of an electrical discharge event can be enhanced. Note that it is preferable to determine whether or not it is a state in which occurrence of an electrical discharge event to be handled is suspected by confirming the degree of continuity of domains in which an output of noise has been confirmed or comparing outputs of noise of a domain group in which a plurality of domains is collected. Note that, the state in which occurrence of an electrical discharge event to be handled is suspected is a state immediately before a stage in which the electrical discharge event can be said to occur or a state in which a noise output of the electrical discharge event can be detected within a certain time.

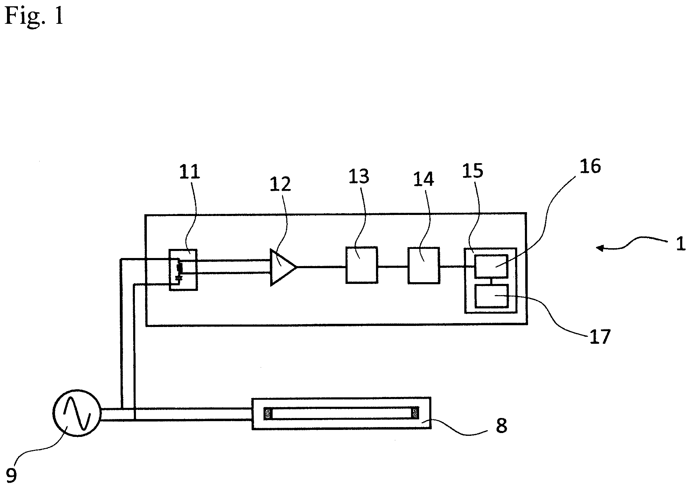

Hereinafter, an outline of an electrical discharge detection unit 1 used in an electrical discharge event determination system according to the embodiment will be described. As can be understood from what is illustrated in Fig. 1, the electrical discharge detection unit 1 of the embodiment is connected between a load 8 and a commercial power source 9, and includes a filter unit 11, an amplification unit 12, a division unit 13, a smoothing unit 14, and a calculation unit 15. Note that, in the example illustrated in Fig. 1, the calculation unit 15 includes a determination unit 16 and a threshold setting unit 17, but the determination unit 16 and the threshold setting unit 17 may be provided separately from the calculation unit 15.

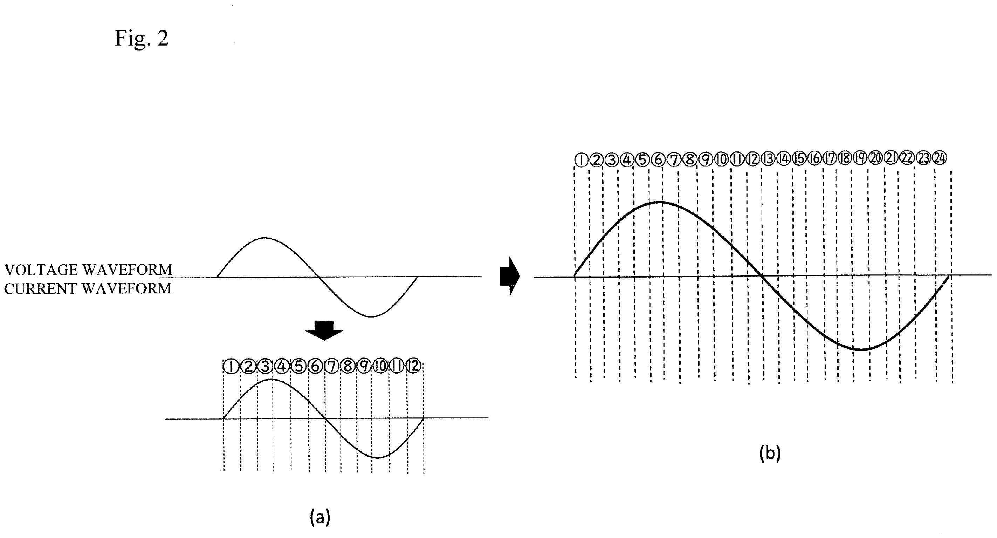

The filter unit 11 of the embodiment passes noise in a high frequency band and does not pass noise in a commercial frequency band and a low frequency band. Further, the amplification unit 12 of the embodiment amplifies a high frequency wave having passed through the filter unit 11. Furthermore, the division unit 13 of the embodiment divides a result amplified by the amplification unit 12 into a plurality of domains for one cycle of a voltage waveform or a current waveform at the commercial frequency (see Fig. 2). Note that, in the example illustrated in Fig. 2, one cycle is divided into 12 domains or 24 domains, but this division may be any number of domains.

Further, the smoothing unit 14 of the embodiment performs preprocessing for enabling determination, and performs processing so that discontinuously obtained data is data that can be regarded as continuous data. Furthermore, the calculation unit 15 of the embodiment can determine continuity of outputs of a plurality of divided domains and compare outputs divided for each of the plurality of domains.

Next, an example of determining continuity of outputs of domains obtained by dividing one cycle of a voltage waveform or a current waveform into a plurality of cycles will be described. Here, an example in which one cycle is divided into 12 domains will be described.

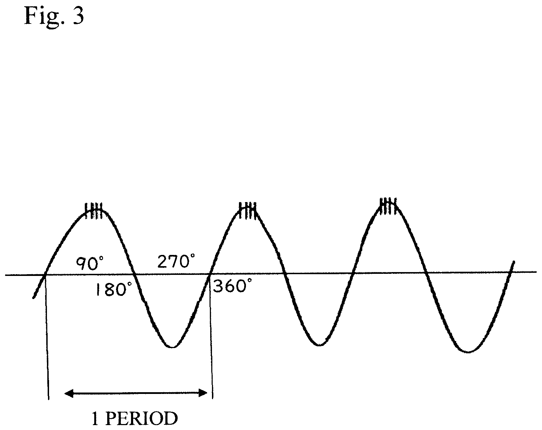

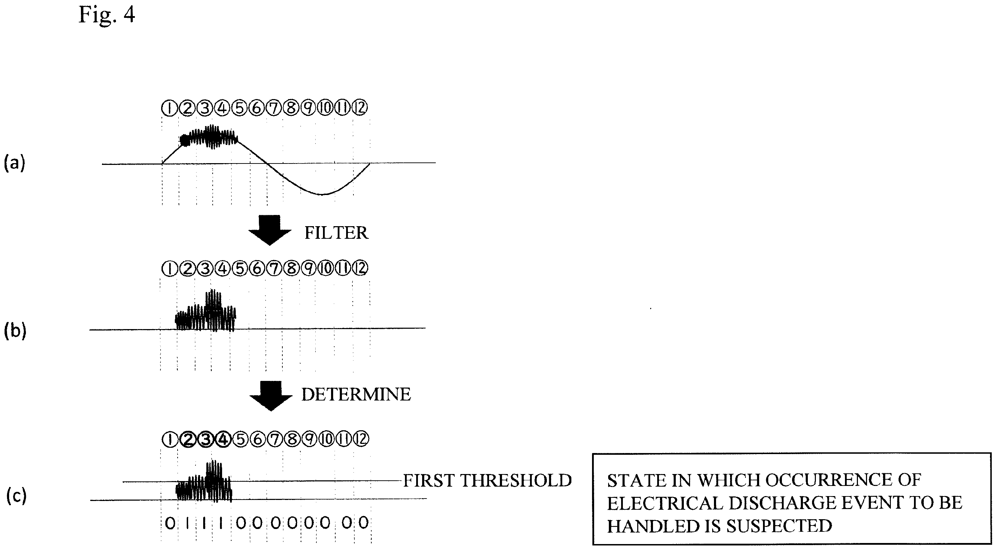

When an electrical discharge event occurs, noise is usually superimposed near a peak. For example, noise is superimposed as illustrated in Fig. 3. An image obtained by dividing this into 12 for one cycle is illustrated in (a) of Fig. 4. Note that, in the embodiment, since the division is performed after the extraction is performed by the filter unit 11, the waveform of one cycle illustrated in (a) of Fig. 4 is not actually divided into 12 pieces.

(b) of Fig. 4 illustrates an example in which data after noise is extracted by the filter unit 11 is divided into 12 for one cycle. Further, (c) of Fig. 4 illustrates an example in which data exceeding a first threshold set by the threshold setting unit 17 is present in some domains. In the example illustrated in (c) of Fig. 4, the second to fourth three domains exceed the first threshold.

Note that a method of determining whether or not a value exceeds a threshold may be any method. For example, it is only required to determine whether or not the average or effective value of outputs of respective domains obtained by division is equal to or more than a threshold for data extracted using the filter unit 11.

It is preferable that the determination unit 16 does not determine that a "state in which occurrence of an electrical discharge event to be handled is suspected" has occurred when a time of being equal to or more than the threshold is less than a certain value, but can determine that a "state in which occurrence of an electrical discharge event to be handled is suspected" has occurred when the time of being equal to or more than the threshold is at least equal to or more than a certain time. Therefore, it is preferable to configure so that, even when the threshold is continuously exceeded for a plurality of times, when this state does not continuously occur for a first predetermined time or more, it is not determined that the "state in which occurrence of an electrical discharge event to be handled is suspected" has occurred, and when continuity of the state exceeding the threshold in one cycle is equal to or more than the first predetermined time (for example, time for three domains), it can be determined that it is the "state in which occurrence of an electrical discharge event to be handled is suspected" has occurred.

However, if noise is also detected in a domain where no noise should be detected, this noise is not due to occurrence of an electrical discharge event. For example, a "peak" in which the absolute value of a current value or a voltage value is larger than those before and after the "peak" and a "zero cross" in which the value becomes 0 (a point where the horizontal line and the waveform overlap in Fig. 3) occur twice in one cycle, but in the "zero cross", the current and the voltage should not exceed the threshold even if the electrical discharge event occurs. When the continuity of the threshold continues even in this time slot, this noise is not caused by occurrence of an electrical discharge event. In this case, it is conceivable that the noise is caused by an operation of another device or the like. Therefore, when it is found that noise has been detected in the domain where no noise should be detected even if an electrical discharge event occurs, it is preferable not to determine that the "state in which occurrence of an electrical discharge event to be handled is suspected" has occurred. For example, it is preferable not to determine that the "state in which occurrence of an electrical discharge event to be handled is suspected" has occurred in a case where the time to exceed the threshold continues unnaturally for a long time even if the time to exceed the threshold is equal to or more than a certain period.

In a case where division into 12 is performed, if continuity in one cycle exceeds, for example, 6 times, the time exceeds 8.35 ms = 16.7 ms/2 in a case of 60 Hz, and a point (0 cross) at which the value becomes at least 0 value is also a point at which noise is output, and thus it is determined that the noise is not due to an electrical discharge event but due to device noise.

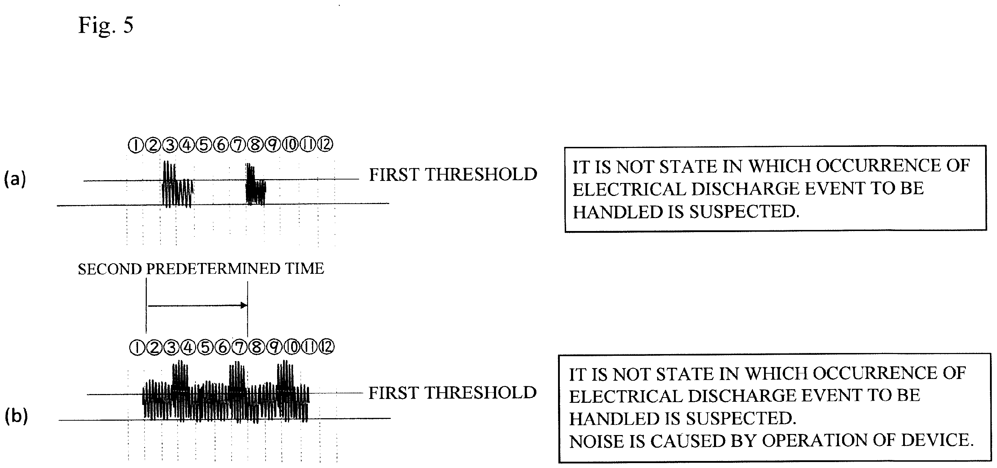

As can be understood from these, when the continuity of the state exceeding the threshold in one cycle is equal to or more than the first predetermined time (for example, time for three domains) and less than a second predetermined time (for example, less than a time for six domains), it is preferable to be able to determine that a "state in which occurrence of an electrical discharge event to be handled is suspected". That is, as illustrated in Fig. 5, when the continuity in one cycle is less than the first predetermined time (for example, time for three domains) or equal to or more than the second predetermined time (for example, time for six domains), it is preferable not to determine that a "state in which occurrence of an electrical discharge event to be handled is suspected" has occurred.

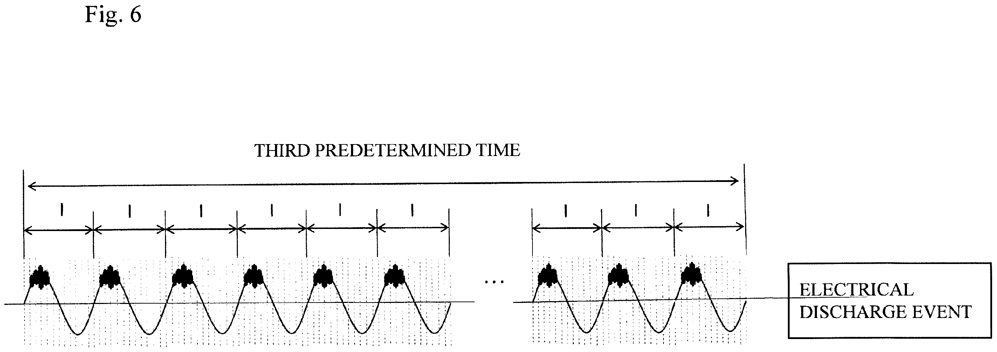

Incidentally, in the above example, it is merely determined whether or not there is a "state in which occurrence of an electrical discharge event to be handled is suspected" by confirming the continuity within one cycle. It is also possible to notify the outside or shut off the circuit on the basis of the determination of a "state in which occurrence of an electrical discharge event to be handled is suspected" in view of the continuity within one cycle. However, the possibility of noise caused by the device cannot be excluded by confirming only one cycle. Therefore, it is preferable to determine whether or not it is a state in which occurrence of an electrical discharge event to be handled is suspected by confirming the degree of continuity of domains in which an output of noise has been confirmed or comparing outputs of noise of a domain group in which a plurality of domains is collected, and it is possible to determine that an "electrical discharge event to be handled has occurred" when the "state in which occurrence of an electrical discharge event to be handled is suspected" is treated to have been detected continuously for a predetermined time (see Fig. 6). Assuming that the predetermined time is a third predetermined time, the third predetermined time may be set to 1 s. With this setting, when the determination of a "state in which occurrence of an electrical discharge event to be handled is suspected" continues about 60 times (16.7 ms × 60 times), it can be determined that the "electrical discharge event to be handled has occurred". In this case, in order to confirm the continuity of the "state in which occurrence of an electrical discharge event to be handled is suspected", the number of times of the occurrence of the "state in which the occurrence of the electrical discharge event to be handled is suspected" is counted, but the time during which the "state in which occurrence of an electrical discharge event to be handled is suspected" is occurring may be directly measured.

Further, even if an electrical discharge event occurs, it is not always possible to confirm all "states in which occurrence of an electrical discharge event to be handled is suspected". There is also a possibility that the "state in which occurrence of an electrical discharge event to be handled is suspected" cannot be confirmed for a moment for some reason. Every time it occurs, it may not be appropriate to treat the "state in which occurrence of an electrical discharge event to be handled is suspected" that has occurred so far as it cannot be used as a basis for determining that the "electrical discharge event to be handled has occurred".

Accordingly, if it is confirmed that the "state in which occurrence of an electrical discharge event to be handled is suspected" for a predetermined time, it is preferable to perform control so as to treat that the "state in which occurrence of an electrical discharge event to be handled is suspected" has been confirmed continuously for a predetermined time even if the "state in which occurrence of an electrical discharge event to be handled is suspected" cannot be confirmed thereafter for an extremely short period.

In the embodiment, even when it is determined that the state is not a state in which occurrence of an electrical discharge event to be handled is suspected, when a state in which it is determined that the state is not a state in which occurrence of an electrical discharge event to be handled is suspected is within a predetermined time at the stage of confirming the continuity of the state in which occurrence of an electrical discharge event to be handled is suspected, control is performed so as to treat that the state in which occurrence of an electrical discharge event to be handled is suspected continues.

For example, after the "state in which occurrence of an electrical discharge event to be handled is suspected" is confirmed three times in succession, control is performed so as to treat that the "state in which occurrence of an electrical discharge event to be handled is suspected" is continuously confirmed for a predetermined time even if the "state in which occurrence of an electrical discharge event to be handled is suspected" cannot be confirmed for an extremely short period. In this case, the "extremely short period" handling is also defined. For example, it can be treated that the "state in which occurrence of an electrical discharge event to be handled is suspected" is continuously confirmed until the "state in which occurrence of an electrical discharge event to be handled is suspected" cannot be confirmed three times.

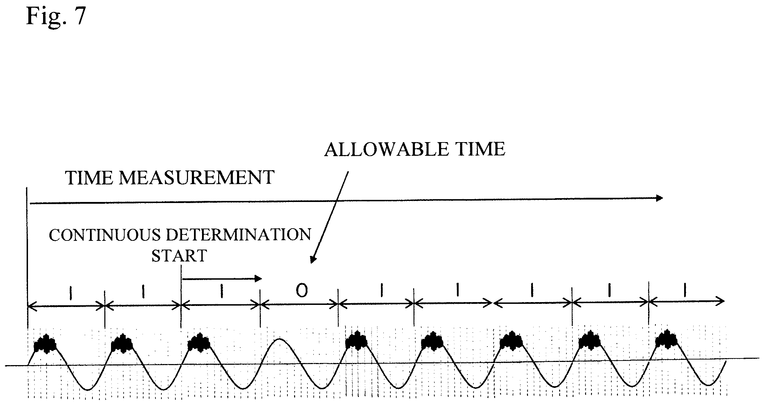

In the example illustrated in Fig. 7, according to this example, first, the "state in which occurrence of an electrical discharge event to be handled is suspected" is confirmed three times in succession, and thereafter, even if the "state in which occurrence of an electrical discharge event to be handled is suspected" cannot be confirmed for an extremely short period, control is performed so as to treat that the "state in which occurrence of an electrical discharge event to be handled is suspected" is continuously confirmed.

The example illustrated in Fig. 8 is also based on this example, and since the "state in which occurrence of an electrical discharge event to be handled is suspected" is confirmed three times in succession, control is performed so as to treat that the "state in which occurrence of an electrical discharge event to be handled is suspected" is continuously confirmed even if the "state in which occurrence of an electrical discharge event to be handled is suspected" cannot be confirmed for an extremely short period thereafter.

In the example illustrated in Fig. 8, even when the "state in which occurrence of an electrical discharge event to be handled is suspected" is not confirmed twice in succession, time measurement for determining whether or not the third predetermined time has elapsed is continued. However, since the "state in which occurrence of an electrical discharge event to be handled is suspected" is not confirmed for three times in succession, the time measurement for determining whether or not the third predetermined time has elapsed is reset. Further, in the example illustrated in Fig. 8, thereafter, since the "state in which occurrence of an electrical discharge event to be handled is suspected" is confirmed, time measurement for determining whether or not the third predetermined time has elapsed is started again.

Note that the start timing of the time measurement for determining whether or not the third predetermined time has been reached is not necessarily the same as the timing at which the "state in which occurrence of an electrical discharge event to be handled is suspected" can be first confirmed. For example, the start timing of the time measurement for determining whether or not the third predetermined time has been reached can be the timing at which control is performed so as to treat that the "state in which occurrence of an electrical discharge event to be handled is suspected" is confirmed continuously for a predetermined time even if the "state in which occurrence of an electrical discharge event to be handled is suspected" cannot be confirmed for an extremely short period.

In the embodiment, "1" is given to the counter when "a state in which occurrence of an electrical discharge event to be handled is suspected" is confirmed, and "0" is given to the counter when "a state in which occurrence of an electrical discharge event to be handled is suspected" is not confirmed, and integration or the like is performed.

For example, when "1" continues three times, measuring time or counting that can be regarded as time is continued until "0" continues three times thereafter. Therefore, even if "0" occurs only once or continues only twice in the state of continuity determination, it is treated as an allowable time. In the embodiment, an allowable time determination means is provided, and even when such an allowable time occurs, the allowable time determination means does not reset the counter for the continuity determination and functions to continue the time measurement.

Note that, here, control is performed so as to treat that, when the "state in which occurrence of an electrical discharge event to be handled is suspected" is confirmed three times, even if the "state in which occurrence of an electrical discharge event to be handled is suspected" cannot be confirmed for an extremely short period thereafter, it is treated that the "state in which occurrence of an electrical discharge event to be handled is suspected" is confirmed continuously for a predetermined time, but the control may be performed other times or such control may not be adopted. For example, control may be performed so as to treat that, when the "state in which occurrence of an electrical discharge event to be handled is suspected" is confirmed twice or four times, even if the "state in which occurrence of an electrical discharge event to be handled is suspected" cannot be confirmed for an extremely short period thereafter, it is treated that the "state in which occurrence of an electrical discharge event to be handled is suspected" is confirmed continuously for a predetermined time. The condition for releasing such control can also be made different from the above-described example.

Incidentally, heretofore, although one cycle is divided into a plurality of domains and continuity in the plurality of domains is used as a basis for determining a "state in which occurrence of an electrical discharge event to be handled is suspected" or the like, one cycle may be divided into a plurality of domains, and noise outputs of the plurality of domains may be compared to determine a "state in which occurrence of an electrical discharge event to be handled is suspected" or the like.

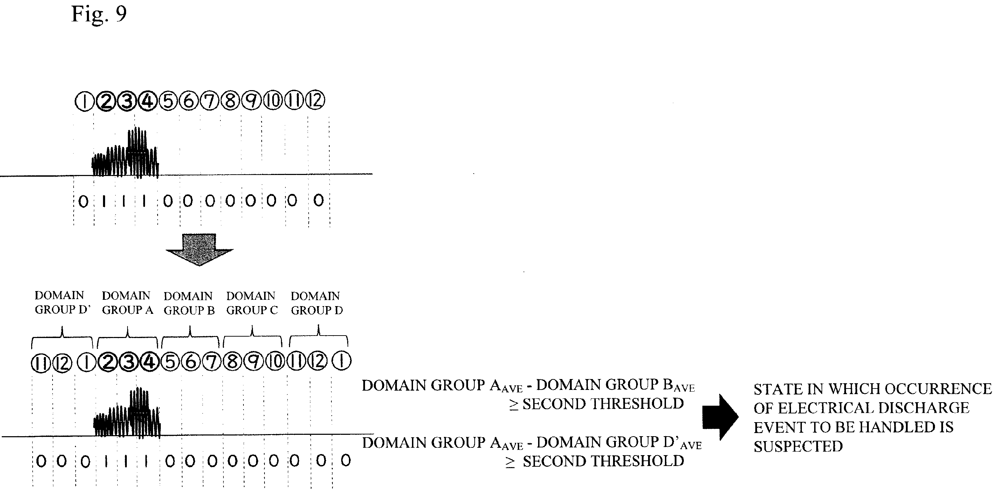

For example, when the domain exceeding the threshold continues to exist for the first predetermined time or more, the domains corresponding to the first predetermined time or the domains continuously exceeding the threshold re set as the domain group A, and the subsequent domain groups of the same predetermined time are set as the domain group B, the domain group C, and the domain group D. Then, the average, the effective value of the outputs of the respective domain groups are output and compared (subtracted) with the output value of the domain group B, which is the domain group after the domain group A, and when the result is equal to or more than the second threshold and/or compared (subtracted or the like) with the domain group D', which is the domain group before the domain group A, and when the result is equal to or more than the second threshold, it can be determined as a "state in which occurrence of an electrical discharge event to be handled is suspected" (see Fig. 9).

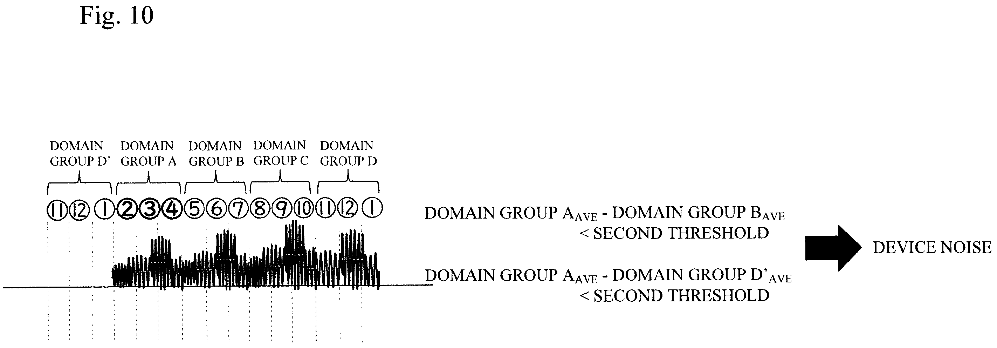

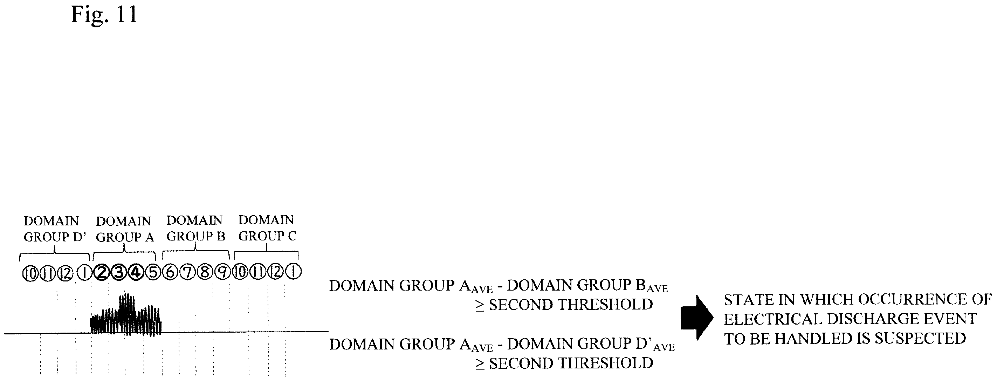

On the other hand, when one of the difference between the domain group A and the domain group B or the difference between the domain group A and the domain group D' is less than the second threshold, it may be determined as device noise (see Fig. 10). Note that, in the examples illustrated in Figs. 9 and 10, a setting time of the domain group A and the like is a length obtained by dividing one cycle into four, but as can be understood from the example illustrated in Fig. 11, the setting time of the domain group A and the like may be other lengths.

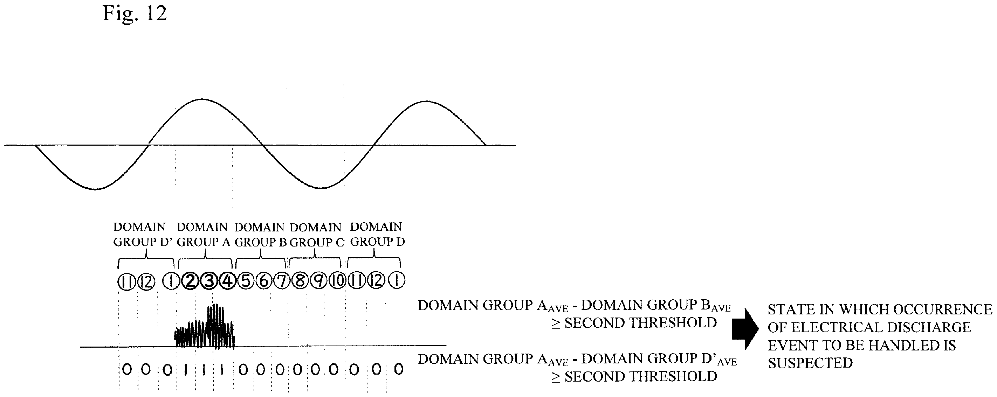

Further, the domain group A may be set in advance to be a peak time domain of the commercial frequency, and the domain group B may be set to be a 0 value time domain of the commercial frequency (see Fig. 12). Note that the peak time domain is a domain before and after the peak at the commercial frequency regarding the output waveform extracted by the filter unit 11, and the 0 value time domain is a domain before and after the output at the commercial frequency becomes 0 value. Typical examples of the peak time domain include a portion of 45 degrees or more and less than 135 degrees and a portion of 225 degrees or more and less than 315 degrees as a phase angle in a case where one cycle is divided into four. Further, typical examples of the 0 value time domain include a portion of 135 degrees or more and less than 225 degrees and a portion of 315 degrees or more and less than 405 degrees as a phase angle in a case where one cycle is divided into four.

Incidentally, the continuity of the "state in which occurrence of an electrical discharge event to be handled is suspected" may be determined using a result of comparing domain groups (see Fig. 13). In this case as well, it can be determined that the electrical discharge event to be handled has occurred when it is recognized that the continuation of the "state in which occurrence of an electrical discharge event to be handled is suspected" continues for a predetermined time. Typically, it can be determined that a highly dangerous electrical discharge event has occurred when the "state in which occurrence of an electrical discharge event to be handled is suspected" continues for a third predetermined time. Even in the case of determining the continuity of the "state in which occurrence of an electrical discharge event to be handled is suspected" using the domain group, it is preferable to perform control so as to treat that the "state in which occurrence of an electrical discharge event to be handled is suspected" is continuously confirmed even if the "state in which occurrence of an electrical discharge event to be handled is suspected" cannot be confirmed for an extremely short period after the "state in which occurrence of an electrical discharge event to be handled is suspected" is confirmed for a predetermined time.

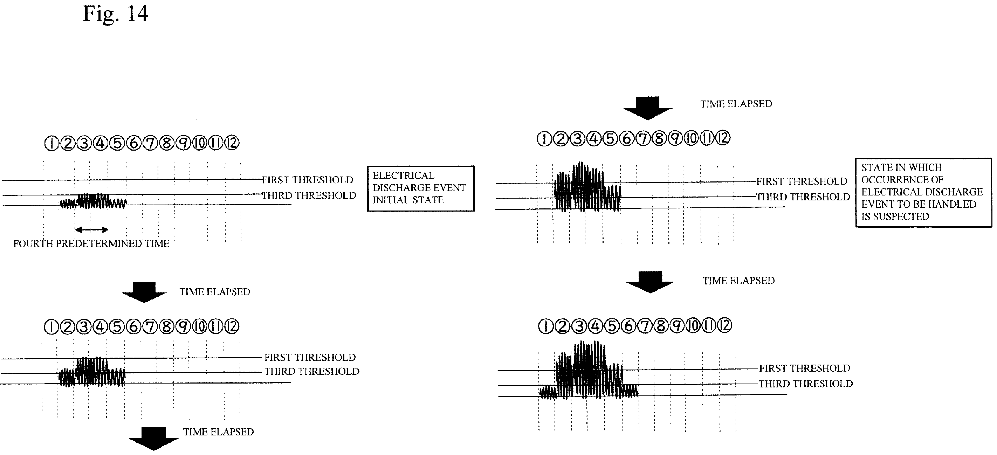

In the embodiment, although the occurrence of the "state in which occurrence of an electrical discharge event to be handled is suspected" is recognized and the determination of the occurrence of the electrical discharge event to be handled is started therefrom, the state of a stage before the recognition of the occurrence of the "state in which occurrence of an electrical discharge event to be handled is suspected" may be grasped in advance. For example, control may be performed so that a third threshold is set lower than the first threshold, and when the third threshold is continuously exceeded for a fourth predetermined time (for example, two domains), it is determined as an "electrical discharge event initial state" (see Fig. 14). Note that, even when it is not determined that the "state in which occurrence of an electrical discharge event to be handled is suspected", the electrical discharge event may actually start to occur. For this reason, in order to increase options such as analysis of data performed after occurrence of an electrical discharge event or after it is confirmed that the "state in which occurrence of an electrical discharge event to be handled is suspected" frequently occurs, it is preferable to configure so that whether or not the state is the "electrical discharge event initial state" can be determined.

Note that, as a result of investigation by the inventors, it has been confirmed that a noise level and a width of a noise cluster are small in the initial stage of electrical discharge, but they increase as the electrical discharge progresses. From this point, the degree of progress of the electrical discharge event can be estimated by confirming a change in the width of the noise cluster or the like. For example, it is also possible to estimate the degree of damage of the cable from the time from the initial state to the occurrence state.

Therefore, the determination unit 16 is preferably configured to be able to determine the degree of progress of the electrical discharge event from the temporal change of data obtained in a domain determined by dividing one cycle into a plurality of domains. More specifically, it is preferably able to determine the degree of progress of the electrical discharge event on the basis of the degree of increase in the number of domains exceeding the threshold or the degree of increase in the output of the electrical discharge noise with the lapse of time.

When the "electrical discharge event initial state" can be confirmed, it is possible to confirm in a stepwise manner such as confirming the "electrical discharge event initial state", confirming the "state in which occurrence of an electrical discharge event to be handled is suspected", and confirming the "occurrence of an electrical discharge event to be handled", and thus it is preferable to use an output unit to notify the user of information thereof and information such as the time when the information is confirmed.

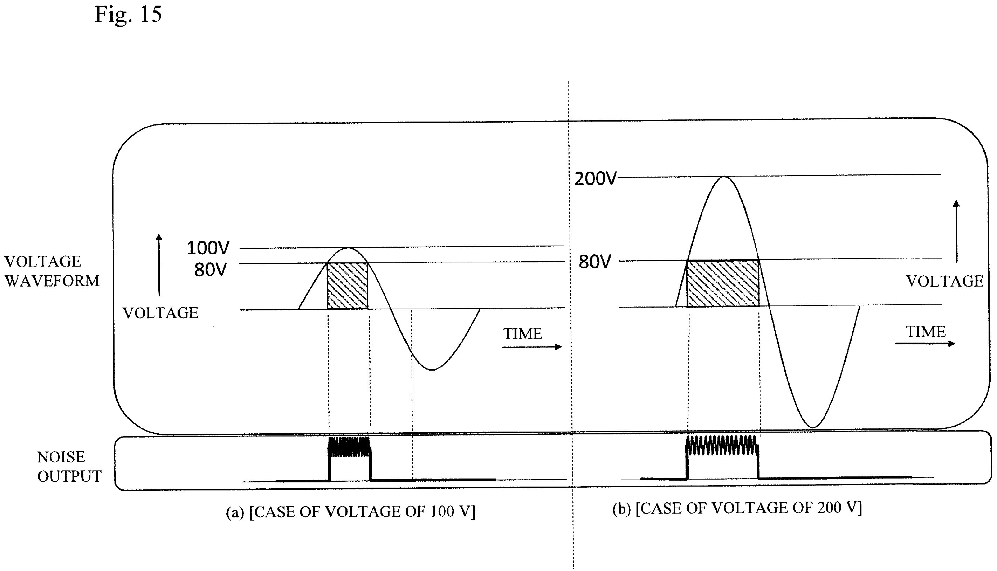

Further, while confirming the data focusing on the spread of the width of the electrical discharge noise, the inventors have found that the noise width is widened in "a case where the voltage is high like three-phase three-wire", "a case where the voltage (current) level of an electrical discharge event is high", and "a case where the electrical discharge event occurs at a place close to the measurement position from the electrical discharge detection unit 1". For example, a power supply voltage of 200 V has a larger noise width than a power supply voltage of 100 V. This is considered to be because, for example, when the level at which the electrical discharge event occurs is equal to or more than 80 V, 200 V is longer than 100 V as the time at which the voltage becomes equal to or more than 80 V (see Fig. 15). Further, for example, if the voltage level at which the electrical discharge event occurs is reduced, this also increases the time to exceed that voltage level.

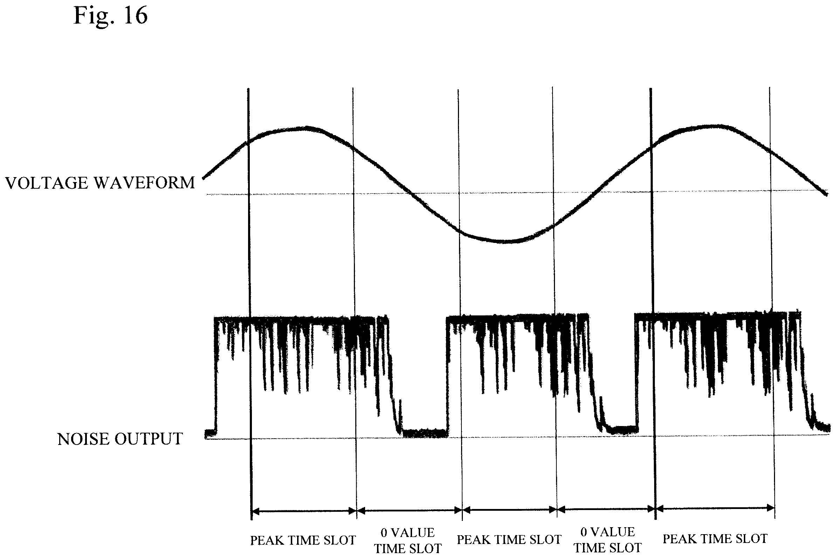

For this reason, a noise output caused by an electrical discharge event may be detected with a temporal length exceeding a length in a case where one cycle is divided into four (see Fig. 16). Specifically, one corresponding to a peak time domain in a case where one cycle is divided into four is set as a peak time slot, and one corresponding to a 0 value time domain is set as a 0 value time slot, a noise output caused by an electrical discharge event may be detected with a time length that does not fall within the range of the peak time slot. In this case, the output value in the 0 value time slot becomes large, and even if comparison is performed using a ratio or a subtraction value between data in the peak time slot and the 0 value time slot data, the output value may not be equal to or more than the threshold. This means that even though a waveform like an electrical discharge event is output, it may not be determined as an electrical discharge event.

Such a problem may be avoided by avoiding comparing the entire data in the peak time slot with the entire data in the 0 value time slot. Therefore, it is preferable to have a configuration in which the noise output can be compared by comparing the domain groups having different numbers of domains.

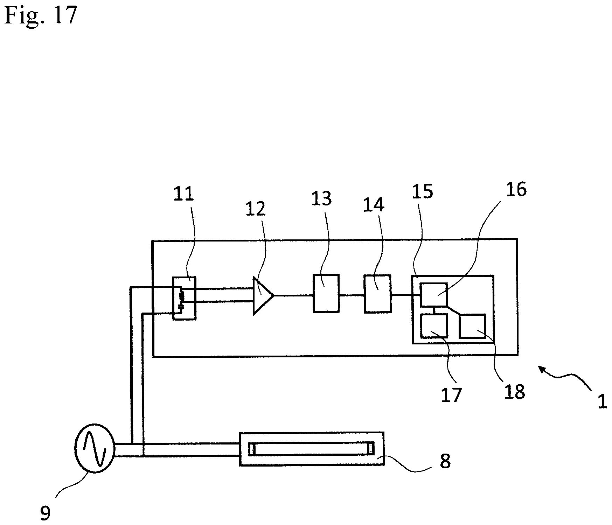

In order to enable such a configuration, the embodiment is configured to include a setting unit that can set so as to exclude an output in a domain of a specific time in any one of the peak time slot and the 0 value time slot from comparison targets. More specifically, this setting unit is a comparison exclusion domain setting unit 18 (see Fig. 17). Since the output in the domain of the specific time can be set to be excluded, the specific domain can be excluded from the comparison targets as necessary, and obstructive factors for determination of the electrical discharge event caused by the installation environment of the electrical discharge detection unit 1 or the like can be eliminated.

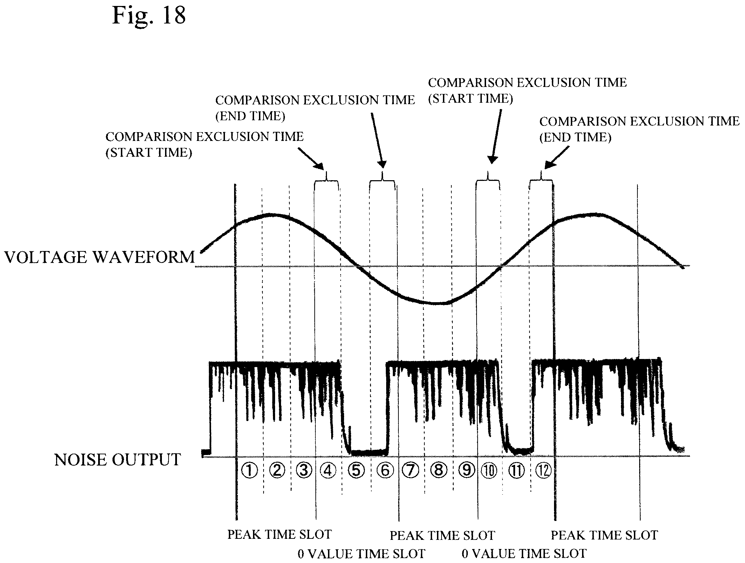

For example, in the example illustrated in Fig. 18, one cycle is equally divided into 12 to set each domain. In this example, the first to third domains and the seventh to ninth domains belong to the peak time slot, and the fourth to sixth domains and the tenth to twelfth domains belong to the 0 value time slot.

In the example illustrated in Fig. 18, in consideration of the spread of noise, the fourth domain and the tenth domain, which are domains at the start time in the 0 value time slot, are set to be excluded from comparison targets, and the sixth domain and the twelfth domain, which are domains at the end time in the 0 value time slot, are set to be excluded from comparison targets. The fourth domain, the sixth domain, the tenth domain, and the twelfth domain are domains located adjacent to the peak time slot among the 0 value time slot domains, and are domains continuous to the peak time slot domain.

When a comparison exclusion time (excluded domain) is set as in the example illustrated in Fig. 18, outputs in the first to third domains are used as an output of the domain group for the first peak time slot of one cycle, and only an output in the fifth domain is used as an output of the domain group for the first 0 value time slot of one cycle. In this case, the determination unit 16 determines whether or not a comparison value (obtained by dividing one value by the other value), a difference value (obtained by subtracting one value by the other value), or the like with respect to the value derived from the outputs in the first to third domains and the value derived from the output in the fifth domain is equal to or more than the second threshold. When the result is equal to or more than the second threshold, it is determined that it is a state in which occurrence of an electrical discharge event to be handled is suspected.

As can be understood from this example, by setting the number of domains being used to be different between the peak time slot and the 0 value time slot when the comparison determination between the peak time slot and the 0 value time slot is performed, it is possible to determine whether or not it is a state in which occurrence of an electrical discharge event to be handled is suspected even under an irregular condition such as a high voltage value or a close noise occurrence place. Note that, regarding outputs of a plurality of domains in the domain group, it is sufficient if an average value, a median value, or the like is used as an output value in the domain group.

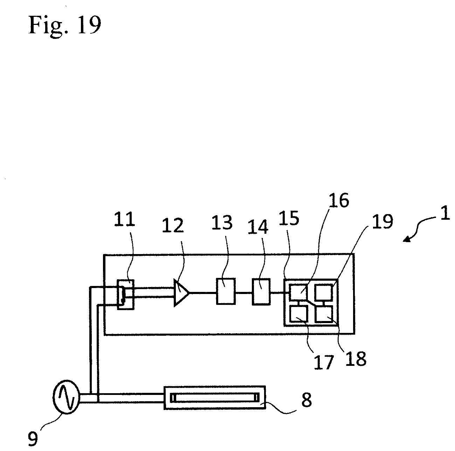

In this example, domains to be excluded by the comparison exclusion domain setting unit 18 are fixed and set in advance. In this case, the domains are always excluded from the comparison targets after setting. However, only when a predetermined condition is satisfied, control may be performed so as to exclude a part of the domains from the comparison targets. For example, as illustrated in Fig. 19, in a case where an exclusion condition setting unit 19 that can set a condition for applying exclusion from the comparison targets is provided, the exclusion condition setting unit 19 may set "to exclude a specific domain from comparison when there is an output that continuously exceeds the first threshold so as to continue from the peak time slot to the 0 value time slot". In this way, the comparison targets at the normal time and the comparison targets meeting certain conditions can be set separately.

In addition, the comparison exclusion domain setting unit 18 and the exclusion condition setting unit 19 may be configured to include a switch (DIP switch) or the like that can determine whether to set.

In the above example, the domains are determined so as to be divided into 12 to divide one cycle, but it is not limited to such an example. For example, it is also possible to set so that the domains are finer than those in a case where 1 cycle is divided into 24, 36, or the like than in a case where 1 cycle is divided into 12. For example, when 24 domains are divided, a plurality of continuous domains can be set to be excluded, for example, the seventh, eighth, eleventh, and twelfth domains are excluded from the comparison targets.

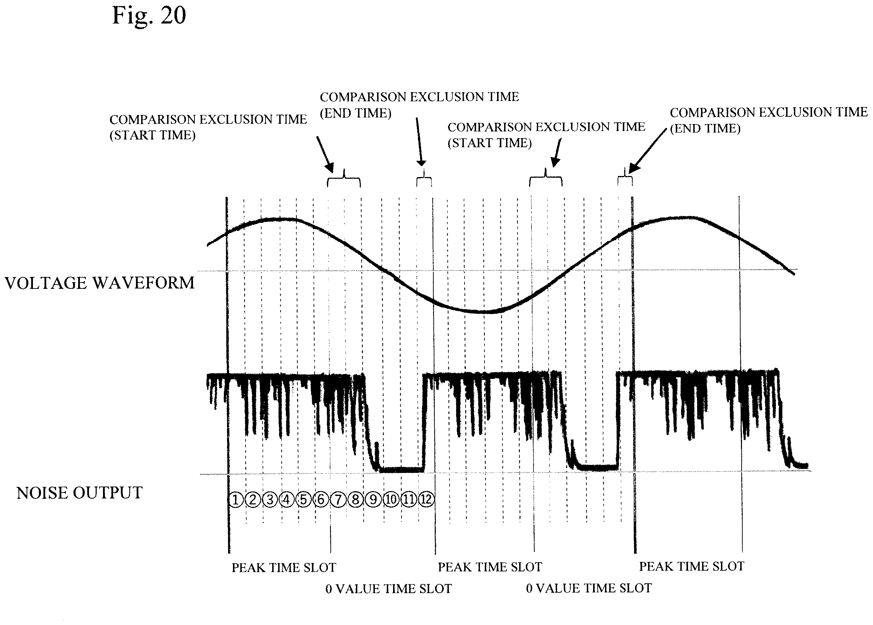

Further, it is not necessary to set the same number of exclusion domains for the start times of the peak time slot and the 0 value time slot and the exclusion domain at the end times of the peak time slot and the 0 value time slot. Different numbers may be set. For example, in the example illustrated in Fig. 20, the exclusion domains at the start time of the 0 value time slot are two domains, and the exclusion domain at the end time of the 0 value time slot is one domain. Therefore, for the first to twelfth domains, the seventh, eighth, and twelfth domains are set to be excluded from the comparison targets.

By making it possible to flexibly adjust the domains excluded from the comparison targets, it is easy to cope with a case where distortion occurs in a voltage waveform, a current waveform, or the like due to the influence of power source equipment or a load, a case where device noise or the like that hinders electrical discharge detection easily occurs in a specific domain such as the vicinity of a peak, or the like.

Also in this example, the determination that the electrical discharge event has occurred is not made only by the determination of one cycle, and the determination that the electrical discharge event has occurred is made by continuously keeping the state in which occurrence of an electrical discharge event to be handled is suspected for the third predetermined time, which is similar to the example described above. In this way, it is possible to suppress erroneous recognition of a sudden change not caused by an electrical discharge event as an electrical discharge event. The third predetermined time can be changed and can be set according to the situation.

Also in this example, the continuity is checked at the time of measuring the third predetermined time. For example, even if "0" occurs only once or continues only twice due to an instantaneous drop of noise, it is treated as an allowable time. Setting of how much instantaneous depression is allowed is preferably changeable.

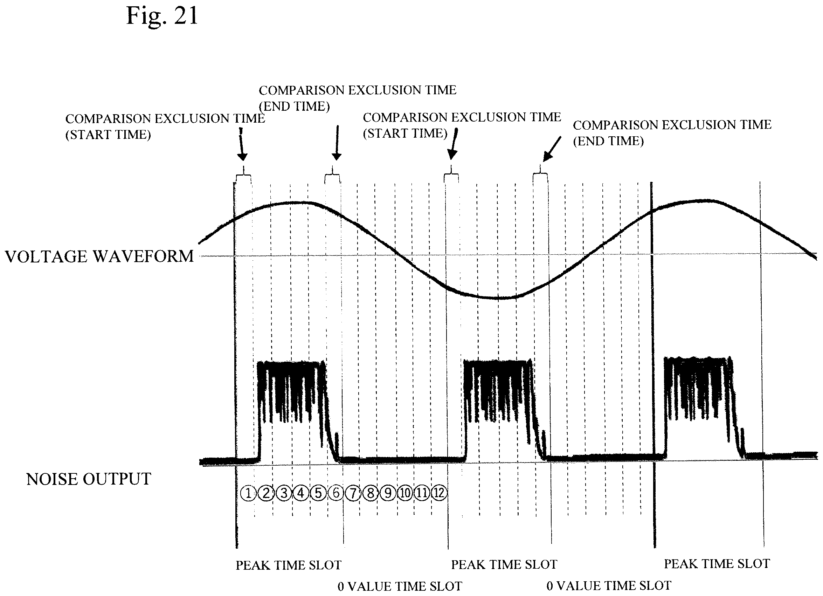

In the examples so far, the description has been given of the response to an increase in the noise width in a case where a generation location is close or in a case where an electrical discharge output is high. On the other hand, in a case where the generation location is far or in a case where the electrical discharge output is low, the noise width may be narrowed (see Fig. 21). In this case, even if a comparison for determination of an electrical discharge event is performed using a ratio or a difference between outputs in the peak time slot and the 0 value time slot, an electrical discharge event may not be determined even though the electrical discharge event has occurred.

In consideration of the above, it is conceivable to set to exclude the start time, the end time from the comparison targets in the peak time slot. For example, the first and sixth domains are excluded from comparison targets. In this case, the second to fifth outputs may be used for the peak time slot, and the seventh to twelfth outputs may be used for the 0 value time slot.

Incidentally, as already described, at the beginning of the electrical discharge event, noise is confirmed near the peak of the waveform, and then the noise width increases. For this reason, when it is desired to measure the electrical discharge event early, it is conceivable that only the vicinity of the peak of the waveform is to be compared. For example, among the first to sixth states illustrated in Fig. 21, the first, second, fifth, and sixth states may be excluded from comparison targets, and only the third and fourth states may be comparison targets.

In the embodiment, the setting as described above can be switched and used using the comparison exclusion domain setting unit 18 provided in the electrical discharge detection unit 1. For example, settings such as "the first, second, fifth, and sixth domains are excluded from comparison targets", "only the first and sixth domains are excluded from the comparison targets", and "there is no domain excluded from the comparison targets" can be made using the comparison exclusion domain setting unit 18.

It is preferable that the comparison exclusion domain setting unit 18 is able to set an excluded domain for both the peak time slot and the 0 value time slot and change the setting according to a desired mode.

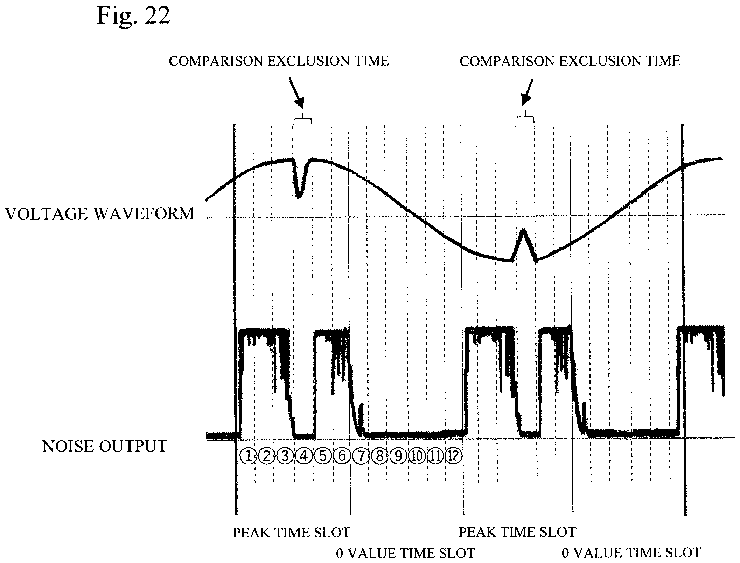

While the domain corresponding to the end (start or end) of the peak time slot or the 0 value time slot is set to be excluded from the comparison targets in the above example, as described above, due to the environmental state such as the state of power source equipment, a load, or a surrounding facility, distortion occurs in the voltage waveform (current waveform) even other than the peak time slot or the start time or end time of the 0 value time slot, and a state in which the voltage (current) decreases or a state in which electrical discharge cannot be detected only in a specific domain may occur (see Fig. 22).

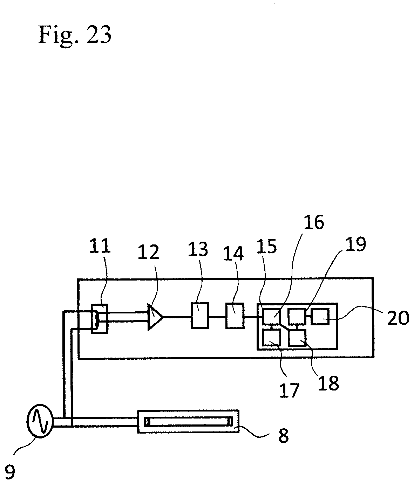

Accordingly, in the example illustrated in Fig. 23, the electrical discharge detection unit 1 includes a learning unit 20. The learning unit 20 is used to collect data for confirming the presence or absence of a state in which electrical discharge cannot be detected depending on the environmental state. As a result of causing the learning unit 20 to function, in a case where it is confirmed that there is a state in which electrical discharge cannot be detected depending on the environmental state, it is possible to automatically set to exclude only a domain at a specific timing from the comparison targets, or it is possible to manually set to exclude a domain at a specific timing from the comparison targets after the user confirms the learning result.

When the presence or absence of a state in which electrical discharge cannot be detected is confirmed using the learning unit 20, and when it is confirmed that there is a state in which electrical discharge cannot be detected, if setting of excluding a specific domain from the comparison targets can be manually or automatically set, it is possible to more accurately determine the presence or absence of occurrence of an electrical discharge event.

As understood from the above description, it is preferable to appropriately select the domain to be excluded from the comparison targets according to the situation, and it is particularly preferable to have a configuration in which the domain settable to be excluded from the comparison targets includes at least a start domain and an end domain in any one of the peak time slot and the 0 value time slot.

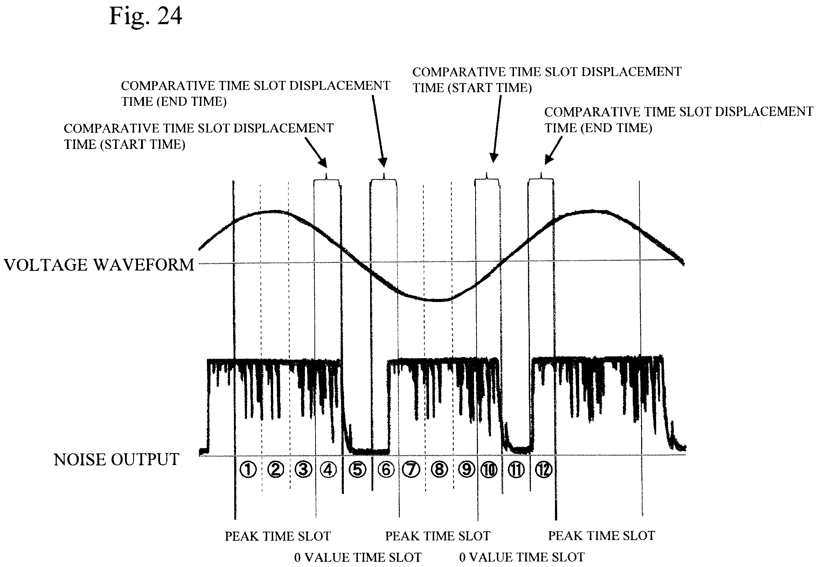

Meanwhile, the excluded domain is not limited to those described above, and may be used as a comparison target in different time slots. For example, in the example illustrated in Fig. 24, a noise output in a domain corresponding to an end (start or end) of the 0 value time slot is related to a group of noise outputs in the peak time slot, and cannot be used as a comparison target of the 0 value time slot but can be used as a comparison target of the peak time slot. In such a case, a domain of a specific time may be used as a comparison target of different time slots. Such a specific time is represented as a comparative time slot displacement time in Fig. 24.

In order to enable such a configuration, it is preferable to include a setting unit capable of setting an output of a domain of a specific time in one of the peak time slot and the 0 value time slot as a comparison target of the other time slot. Furthermore, domains set as comparison targets in the other time slot preferably include at least a start domain and an end domain in any one of the peak time slot and the 0 value time slot.

After such setting processing, comparison for determination of an electrical discharge event is performed using a ratio or a difference between data treated as a comparison target of the peak time slot and data treated as a comparison target of the 0 value time slot. Note that, in a case where there is output that exceeds the first threshold continuously so as to continue from the peak time slot to the 0 value time slot, control may be performed so as to set the data of the specific domain as a comparison target of the other time slot. Furthermore, domains settable to be excluded from the comparison targets preferably includes a start domain and an end domain in any one of the peak time slot and the 0 value time slot in the 0 value time slot.

Incidentally, the contents described so far relate to a method of determining whether or not extracted noise is noise caused by a device and a method of determining an electrical discharge event in a situation where no noise caused by a device occurs. However, in the contents described so far, it is possible to determine whether or not the extracted noise is noise caused by a device, but in a situation where the noise caused by a device occurs, it may be difficult to confirm occurrence of an electrical discharge event. In this case, the occurrence of the electrical discharge event is confirmed after waiting for the device that generates the noise to stop. However, even in a situation where the noise caused by a device occurs, if it can be grasped that an electrical discharge event has occurred, it is possible to quickly respond to the electrical discharge event.

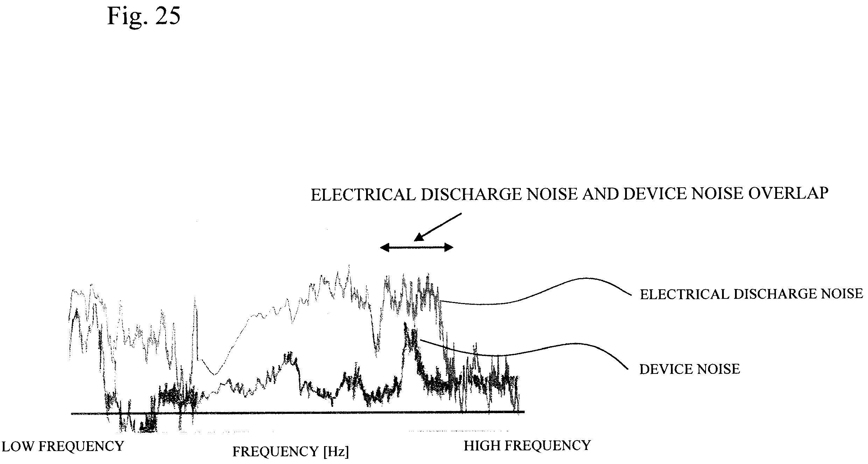

On the other hand, as a result of the investigation by the inventors, it has been confirmed that even in a case where superimposition of noise caused by a device has been confirmed, when the frequency band to be extracted by the filter unit 11 is changed, the superimposition of the noise caused by the device may become small or may not be confirmed (see Fig. 25). From this point, it can be said that a plurality of frequency bands can be extracted.

In order to have a configuration in which a plurality of frequencies can be extracted, it is preferable to have a configuration in which a plurality of filter units 11 is provided and a frequency band different from a frequency band extracted by a certain filter unit 11 can be extracted by another filter unit 11. More specifically, it is preferable that a plurality of filter units 11 is provided so that at least one of the filter units 11 is capable of extracting an output waveform in a frequency band different from that of another of the filter units 11, and it is possible to perform control so as to determine continuity in a plurality of domains or compare noise outputs in each of the plurality of domains to determine suitability of each of the filter units 11.

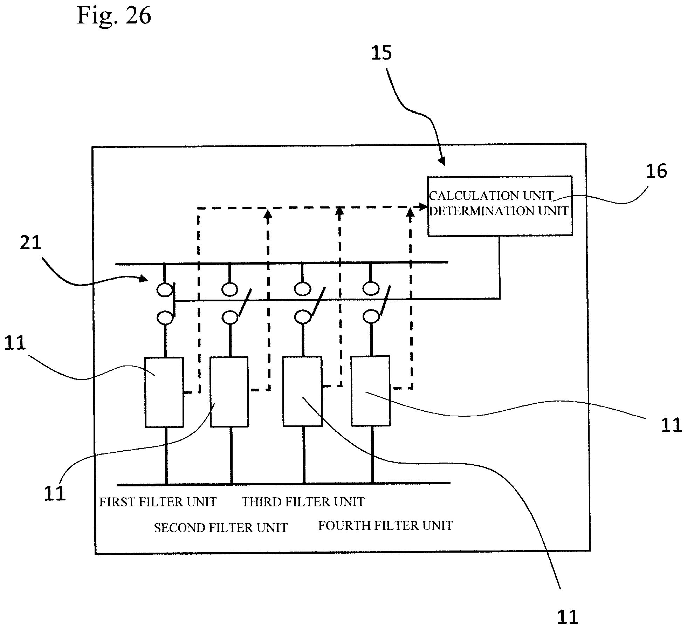

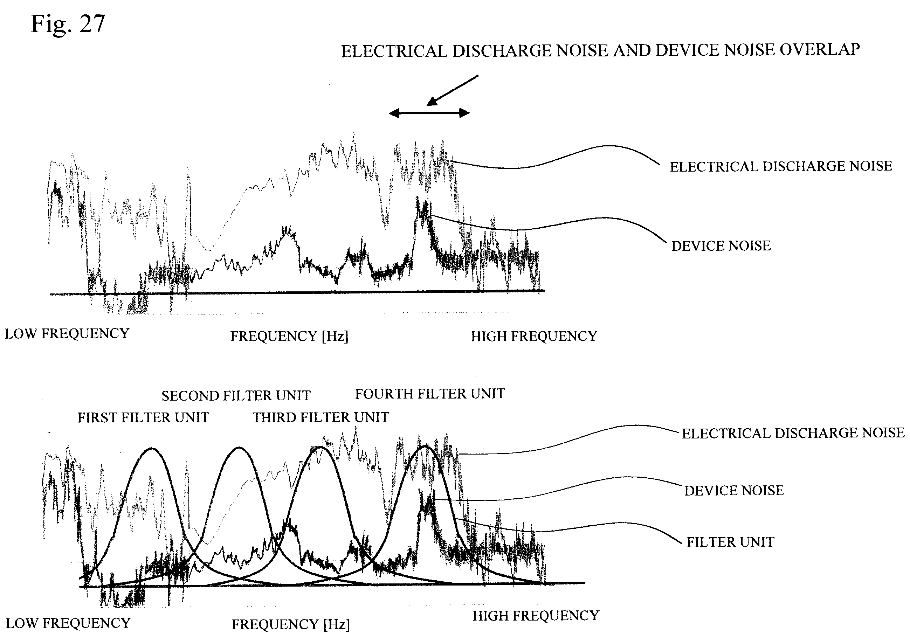

For example, as illustrated in Fig. 26, four filter units 11 are provided. These filter units 11 are configured so that frequency bands to be extracted are different from each other (see Fig. 27). For example, whether or not the noise caused by the device interferes with detection of an electrical discharge event is confirmed for the filter units 11, and if there is a filter unit 11 in which the noise caused by the device does not interfere with the detection of the electrical discharge event, the electrical discharge event may be detected using the filter unit 11. In the example illustrated in Fig. 26, a switching unit 21 that can be used to switch the filter unit 11 is provided so as to correspond to each filter unit 11.

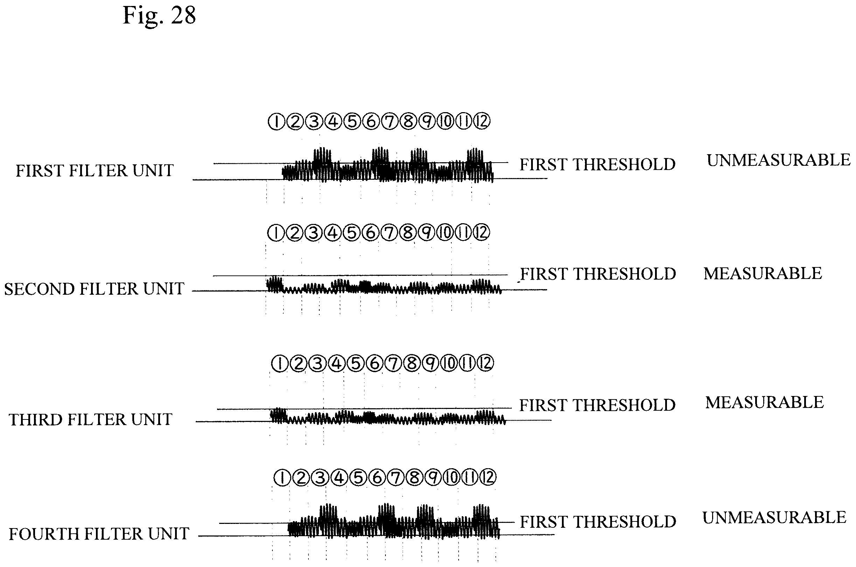

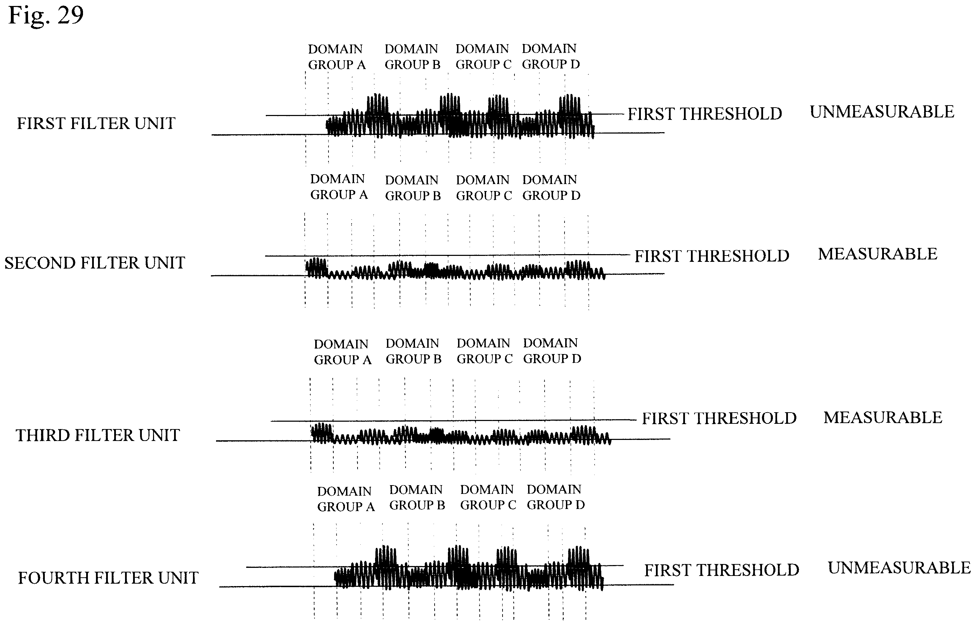

In the stage of confirming whether or not the noise caused by the device interferes the detection of the electrical discharge event, for example, continuity of a domain where detection equal to or more than the first threshold is performed may be confirmed (see Fig. 28). Of course, other means may be used, and for example, four domain groups, which are a plurality of clusters of domains, may be set from a domain group A to a domain group D, and it may be determined whether or not each output exceeds the first threshold to confirm whether or not the noise caused by the device interferes with the detection of the electrical discharge event (see Fig. 29). In addition, each domain may be divided into a peak time domain and a 0 value time domain in advance, and it may be determined whether an output in the 0 value time domain exceeds the first threshold, and it may be confirmed whether or not noise caused by the device interferes with the detection of the electrical discharge event. Of course, the determination criterion does not need to be the first threshold, and other thresholds may be separately set.

As a result of performing such work, for example, it is assumed that it is found that two of the four filter units 11 cannot detect an electrical discharge event due to the noise caused by the device, but the remaining two can detect an electrical discharge event. In this case, the electrical discharge event may be detected using at least any one of the filter units 11. Such an operation is preferably performed in advance at a normal time.

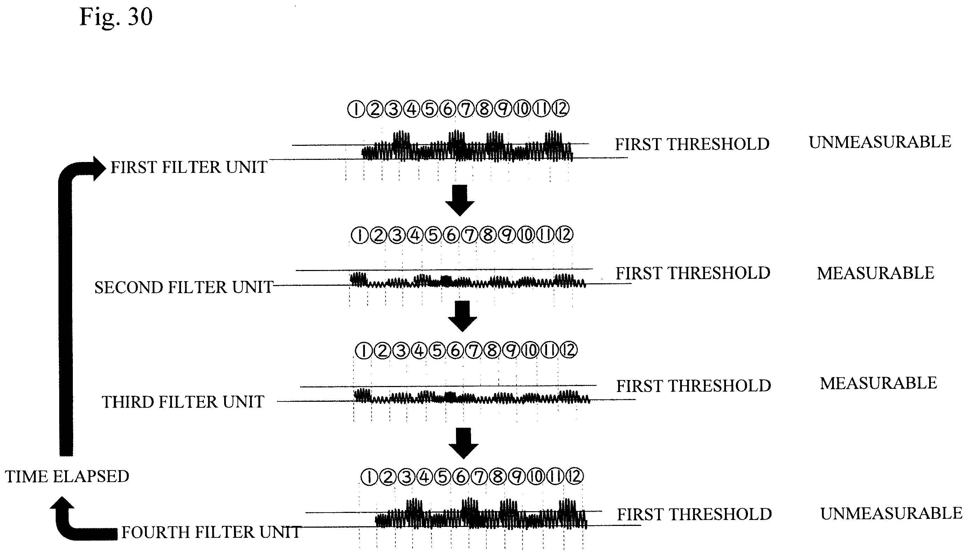

Further, which filter unit 11 can be used may be confirmed at predetermined time intervals. This is because the available environment of the filter unit 11 can change depending on use states of devices arranged in the periphery. For example, it is assumed that it has been confirmed that the "second filter unit 11" and the "third filter unit 11" can be used during the first operation. However, even these filter units 11 may be in a state unsuitable for detection of an electrical discharge event depending on the use state of devices arranged in the periphery. Therefore, it is preferable to perform control so that after a predetermined time (for example, an hour) has elapsed since it is confirmed once, suitability of all the filter units 11 is determined again, and the filter unit 11 to be used is selected again as necessary (see Fig. 30).

Note that, in some cases, it is also conceivable that a situation in which all of the plurality of arranged filter units 11 cannot detect the electrical discharge event occurs. Therefore, in a case where it is determined that all the filter units 11 are not suitable for detecting the electrical discharge event, it is preferable to perform control to output the fact so that the fact can be grasped externally. In order to enable such a configuration, in the embodiment, control is performed so as to output a warning when it is determined that all of the filter units 11 capable of extracting output waveforms in different frequency bands are not suitable.

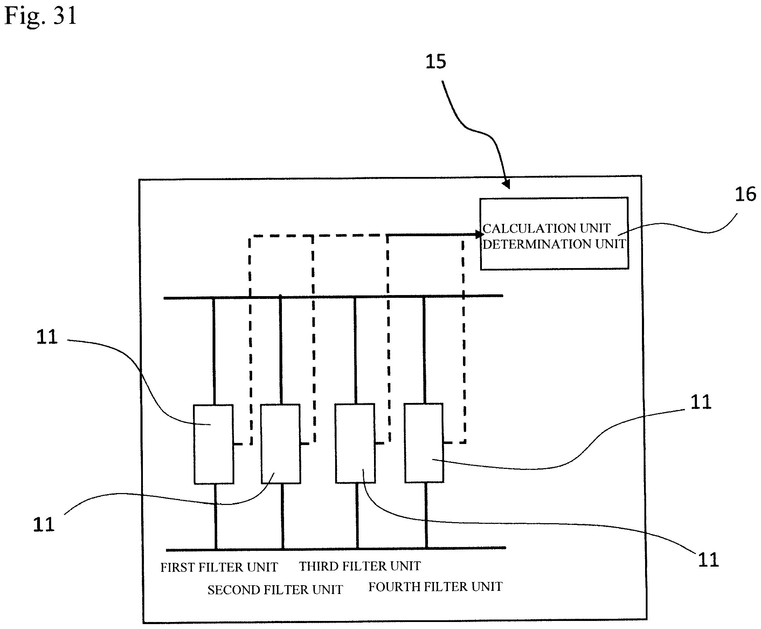

Meanwhile, in a case where a plurality of filter units 11 is installed, the measurement may be performed while switching the filter units 11, or the measurement may be performed by all the filter units 11 at all times. In the case of a configuration in which all the filter units 11 always perform measurement (see Fig. 31), in a case where there is at least one filter unit 11 capable of performing measurement, determination regarding an electrical discharge event can be performed by using data obtained by any of the filter units 11 capable of performing measurement. In addition, in a case where a plurality of the filter units 11 is capable of performing measurement, the determination regarding the electrical discharge event may be performed using data obtained by the plurality of filter units 11.

Although the present invention has been described by taking the embodiments as examples, the present invention is not limited to the above embodiments, and various aspects can be adopted. For example, the present invention is not limited to the case of alternating current, and the present invention may be used with direct current. In addition, even in the case of alternating current, the certain time is not limited to dividing one cycle into a plurality of cycles, and a half cycle or two cycles of one cycle may be set as the certain time. In addition, in the case of direct current, a certain time may be set as a predetermined time. Of course, it is preferable that the predetermined time can be freely changed.

### REFERENCE SIGNS LIST

- 1: Electrical discharge detection unit
- 8: Load
- 11: Filter unit
- 13: Division unit
- 16: Determination unit

## Claims

1. An electrical discharge detection system that detects an output of noise superimposed on a voltage or a current of an electric circuit to which a load is connected, the electrical discharge detection system comprising:
a filter unit capable of extracting an output waveform in a specific frequency band;
a division unit capable of dividing a certain time into a plurality of domains; and
a determination unit capable of confirming a degree of continuity of domains in which an output of noise has been confirmed or comparing outputs of noise of a domain group in which a plurality of domains is collected.

2. The electrical discharge detection system according to claim 1, wherein
whether or not it is a state in which occurrence of an electrical discharge event to be handled is suspected is determined by confirming the degree of continuity of domains in which an output of noise has been confirmed or comparing outputs of noise of a domain group in which a plurality of domains is collected, and
it is possible to determine that an electrical discharge event to be handled has occurred when the state in which occurrence of an electrical discharge event to be handled is suspected is treated to have been detected continuously for a predetermined time.

3. The electrical discharge detection system according to claim 2, wherein, even when it is determined not to be the state in which occurrence of an electrical discharge event to be handled is suspected at a stage of confirming continuity of the state in which occurrence of an electrical discharge event to be handled is suspected, when a state in which it is determined not to be the state in which occurrence of an electrical discharge event to be handled is suspected is within a predetermined time, control is performed so as to treat that the state in which occurrence of an electrical discharge event to be handled is suspected as continuing.

4. The electrical discharge detection system according to any one of claims 1 to 3, wherein the determination unit is capable of determining a degree of progress of the electrical discharge event from a temporal change in data obtained in a domain determined by dividing a certain time into a plurality of times.

5. The electrical discharge detection system according to any one of claims 1 to 3, further comprising:
a plurality of filter units is provided so that at least one of the filter units is capable of extracting an output waveform in a frequency band different from a frequency band of another of the filter units, wherein
it is possible to perform control so as to determine continuity in a plurality of domains or compare noise outputs in each of the plurality of domains to determine suitability of each of the filter units.

6. The electrical discharge detection system according to claim 5, wherein control is performed so as to output a warning when it is determined that all the filter units capable of extracting output waveforms in mutually different frequency bands are not suitable.

7. The electrical discharge detection system according to any one of claims 1 to 3, wherein it is possible to compare noise outputs by comparing domain groups having different numbers of domains.

8. The electrical discharge detection system according to claim 7, further comprising a setting unit capable of setting so as to exclude an output in a domain of a specific time in any one of a peak time slot and a 0 value time slot from comparison targets.

9. The electrical discharge detection system according to claim 8, wherein domains settable to be excluded from the comparison targets include at least a start domain and an end domain in any one of the peak time slot and the 0 value time slot.

10. The electrical discharge detection system according to claim 7, further comprising a setting unit capable of setting an output in a specific time domain in one of the peak time slot and the 0 value time slot as a comparison target in another of the time slots.

11. The electrical discharge detection system according to claim 10, wherein domains settable to be included in comparison targets include at least a start domain and an end domain in any one of the peak time slot and the 0 value time slot.
